# EUROPEAN PATENT APPLICATION

(11) **EP 0 959 562 A1**
(43) Date of publication of application: **24.11.1999**
(21) Application number: 98830311.1
(22) Date of filing: 21.05.1998
(51) Int. Cl.: H03K 17/567

(54) **A circuit for controlling the switching of a load by means of an emitter-switching device**

(71) Applicant: STMicroelectronics S.r.l., 20041 Agrate Brianza (Milano) (IT)
(72) Inventor: Aiello, Natale, 95123 Catania (IT); La Barbera, Atanasio, 95030 Mascalucia - Catania (IT)
(74) Representative: Maggioni, Claudio

(57) **Abstract**

The circuit controls the switching of a load (RL) between two supply terminals (Vdd, ground) by means of a device (10) in an emitter-switching configuration constituted by a high-voltage, bipolar power transistor (Q) with its collector connected to the load (RL) and by a low-voltage switch element (M) having a first terminal connected to the emitter of the bipolar power transistor (Q), a second terminal connected to ground, and a control terminal (13) connected to the control terminal (12) of the circuit. The circuit has biasing means (11) connected to the base terminal of the bipolar power transistor (Q). To ensure that the bipolar power transistor (Q) operates in the saturation region throughout the period of conduction, even with a sinusoidal driving voltage (Vin), the biasing means (11) comprise capacitive means (C) and means (Vin, D1; D2; Vdd, R2) for charging the capacitive means (C) so as to bias the base of the bipolar transistor.

## Description

The present invention relates to circuits for controlling the switching of a load, particularly those which comprise a device in an "emitter-switching" configuration, as defined in the preamble of Claim 1.

A typical device in an emitter-switching configuration is constituted by a bipolar power transistor for high-voltage uses and by a field-effect transistor for high-frequency and low-voltage uses, connected to one another with the emitter terminal of the former connected to the drain terminal of the latter. The former component is selected to withstand high voltages and the latter is selected to avoid the poor performance of the former during switching, in operation. A switch element of another type, for example, a bipolar transistor for high frequency and low voltage, may be used instead of the field-effect transistor.

Typically, the high-voltage transistor has an open-emitter collector-base breakdown voltage (BVcbo) which may be up to 2000V, whereas the low-voltage transistor has a breakdown voltage of about 60V. This configuration is advantageously used in circuits for controlling the switching of a load in which the switching speed is important. The working frequency in this type of configuration may be several hundred kHz.

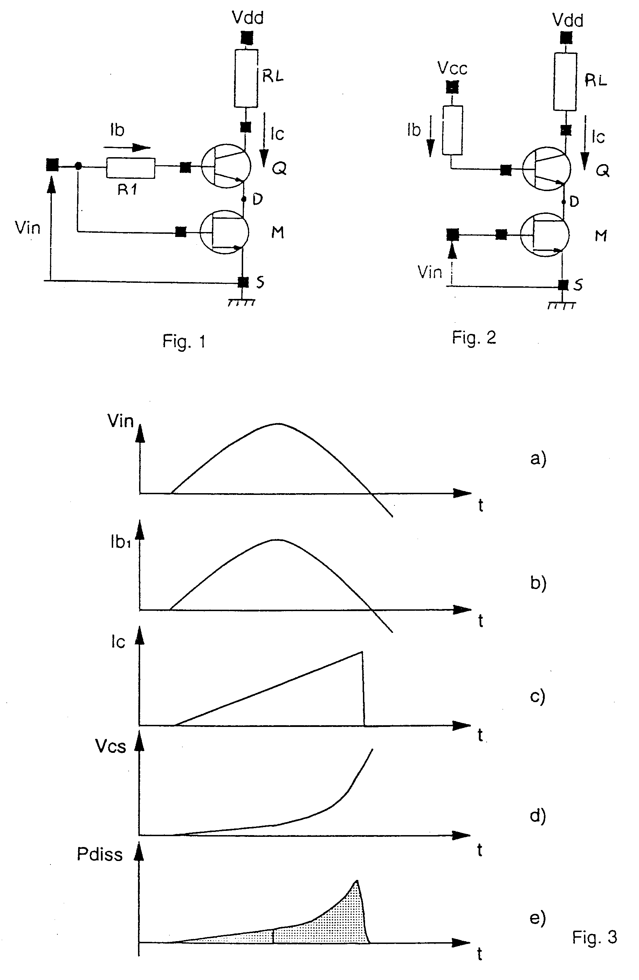

Various methods are known for driving a device in an emitter-switching configuration. Amongst these, two which are most often used are: that shown in Figure 1, in which both the base terminal of the bipolar power transistor Q and the gate terminal of the field-effect transistor M are driven by the same input signal Vin, the two terminals being disconnected by means of a resistor R1, and that shown in Figure 2, in which only the gate terminal of the field-effect transistor M is driven by the input signal Vin, whilst the base terminal of the bipolar power transistor Q is connected to a constant voltage supply Vcc which, in many cases, is different from the voltage supply Vdd of the load RL.

The system of Figure 1 is used without problems in all cases in which the driving signal Vin is a rectangular wave, but is not very efficient if the waveform of the driving signal is sinusoidal. The system of Figure 2 does not have this problem but may require a voltage supply Vcc separate from the main supply Vdd for biasing the base of the bipolar power transistor. In certain applications, this additional supply has to be at a voltage higher than the main voltage and this creates constructional problems and, in any case, complicates the circuit.

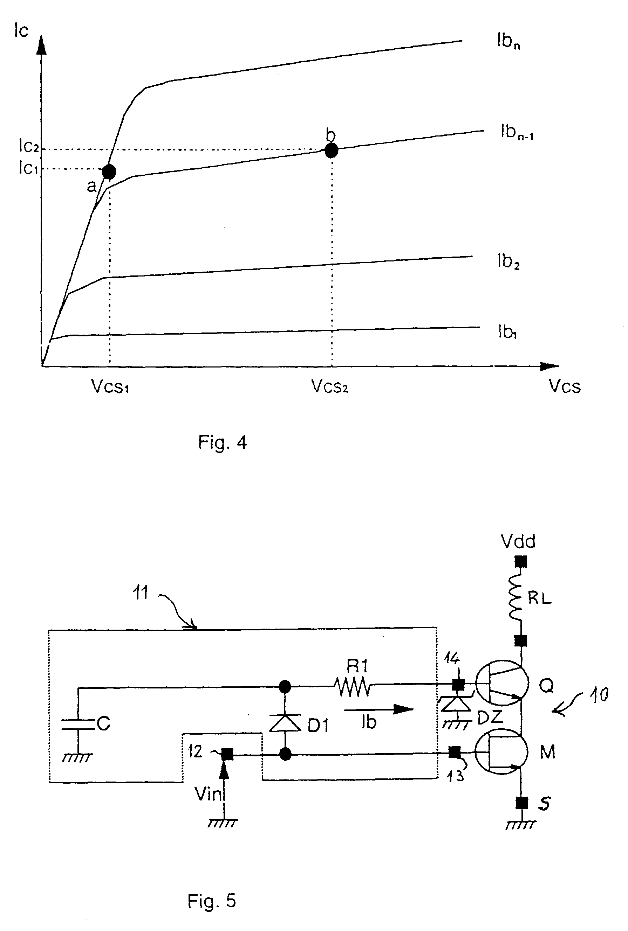

A sinusoidal input voltage signal Vin, as shown in Figure 3a), and an inductive load RL are considered with reference to the system of Figure 1. It is easy to see that the base current Ib is also sinusoidal, as shown in Figure 3b), and that the collector current Ic has a triangular wave-form, as shown in Figure 3c). This means that the maximum value of the base current occurs not when the collector current is at a maximum but at a moment at which the collector current has a value below the maximum value. In these operative conditions, since collector current Ic flowing through the bipolar power transistor Q increases as the base current Ib decreases, its working point may move from the saturation region to the active region, as shown in Figure 4. This drawing shows the characteristic curves of the collector current Ic as a function of the voltage Vcs between the collector of the bipolar transistor Q and the source terminal of the field-effect transistor M, for various values of the base current Ib. Two working points, indicated a and b are shown in the drawing and correspond to two collector-current values Ic1 and Ic2, respectively. The former is on a characteristic curve corresponding to a base current Ibn and is in the saturation region of this curve, that is, at a low voltage Vcs1 of the collector relative to the ground terminal, and the latter is on a characteristic curve corresponding to a base current Ibn-1 less than the current Ibn, and is in the active region of this curve, that is, at a high voltage Vcs2 of the collector relative to ground.

The curve of the voltage Vcs between the collector and ground in the positive half-period of the input voltage Vin is shown in Figure 3d). This method of driving the device in an emitter-switching configuration thus causes the bipolar power transistor Q to operate in the active region of its characteristic curve during part of the time during which it should behave as a closed switch, and thus also causes an increase in the power dissipated Pdiss, as shown in Figure 3e).

With the driving system of Figure 2, the base current Ib also decreases as the collector current Ic increases during part of the time when the bipolar power transistor Q is conductive, but the effects of this are negligible if the biasing voltage Vcc selected is greater, to a sufficient extent, than the sum of the voltage drop Vbe between the base and the emitter of the bipolar transistor Q and the voltage drop Vds between the drain and source terminals D and S of the field-effect transistor M.

The object of the present invention is to propose a circuit for controlling the switching of a load by means of a device in an emitter switching configuration, in which the bipolar power transistor operates in the saturation region throughout the time for which it is conductive, even with a sinusoidal driving voltage, and in which no additional supplies are required.

This object is achieved, according to the invention, by the provision of a circuit as defined and characterized in general in the first claim.

The invention will be understood further from the following detailed description of three embodiments thereof given by way of non-limiting example with reference to the appended drawings, in which:
Figures 1 and 2 are two circuit diagrams which show two known methods of driving a device in an emitter switching configuration,
Figure 3 shows graphs illustrating the operation of the circuit of Figure 1, driven by a sinusoidal voltage,
Figure 4 shows some characteristic current/voltage curves of the bipolar power transistor of the circuit of Figure 1,
Figure 5 is a circuit diagram according to a first embodiment of the invention,
Figure 6 is a graph illustrating the operation of the circuit of Figure 5,
Figure 7 is a circuit diagram according to a second embodiment of the invention,
Figure 8 is a graph illustrating the operation of the circuit of Figure 7,
Figure 9 is a circuit diagram according to a third embodiment of the invention, and
Figure 10 is a graph showing the operation of the circuit of Figure 9.

In Figure 5, an emitter-switching device, generally indicated 10, is formed by an npn-type bipolar transistor, indicated Q, and by an n-channel field-effect transistor, indicated M. The collector of the transistor Q is connected to a terminal of a load RL which, in this example, is an inductive load, the other terminal of which is connected to the positive pole, indicated Vdd, of a voltage supply. The source terminal S of the transistor M is connected to the negative pole, indicated by the ground symbol, of the voltage supply. A circuit, generally indicated 11, biases the base of the bipolar transistor Q and controls the switching of the device 10 in dependence on a sinusoidal input voltage Vin. An input terminal 12 is connected to the gate terminal 13 of the transistor M and to the anode of a diode D1. A capacitor C is connected, on one side, to a reference-voltage terminal, in this example, to the ground terminal and, on the other side, to the base terminal 14 of the transistor Q, via a resistor R1, in order to supply a biasing voltage to the base of the transistor Q. The cathode of the diode D1 is connected to the point at which the capacitor C is connected to the resistor R1.

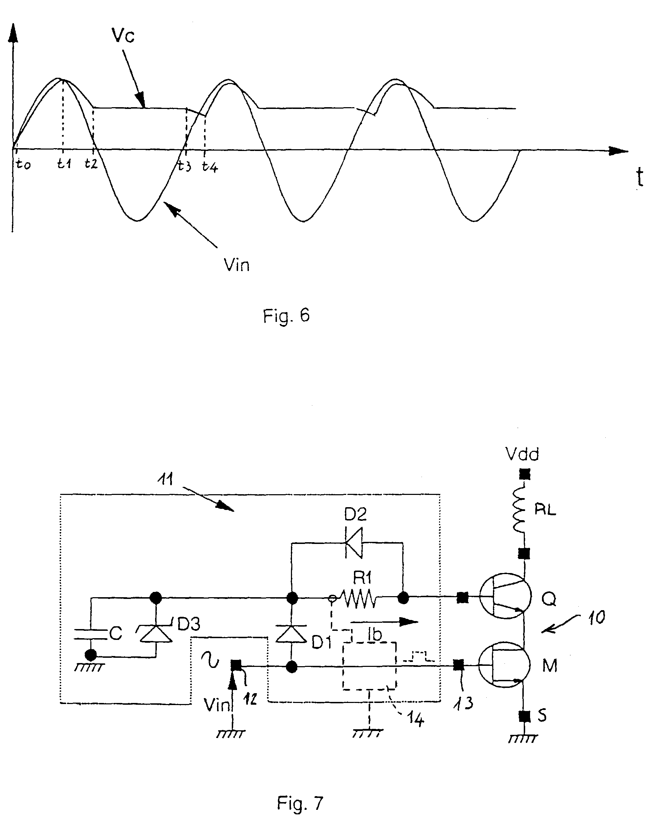

The operation of the circuit of Figure 5 will now be considered with reference to the graph of Figure 6 which shows the input voltage Vin and the voltage Vc across the capacitor C as functions of time.

At a time t0, the capacitor C is discharged. As the voltage Vin increases, the capacitor C is charged through the diode D1, following the curve of Vin except for the drop in the diode D1 which is biased in the direction of conduction. As soon as the threshold voltage of the transistor M is exceeded, this transistor becomes conductive, allowing a current Ib to pass through the resistor R1 and the base-emitter junction of the transistor Q. The transistor Q thus also becomes conductive.

At a time t1, that is, shortly after the beginning of the trailing edge of the voltage Vin from the peak of the first positive half-wave, the voltages Vin and Vc are equal. Immediately afterwards, however, the voltage Vin falls more rapidly than the voltage Vc so that the diode D1 ceases to conduct. The charge for keeping the transistor Q conductive is now supplied by the capacitor C.

When the transistor M is cut off at a time t2, the transistor Q also ceases to conduct and the voltage Vc in the capacitor C remains substantially constant until, shortly after the start of the next positive half-wave, the transistors M and Q become conductive again at a time t3. The capacitor C still supplies charge to the transistor Q until the voltage Vin exceeds the voltage Vc by a value equal to the conduction threshold of the diode D1 at a time t4. The voltage Vin thus starts charging the capacitor C and supplying the base of the transistor Q again, and the cycle is repeated.

It will be noted that, to prevent over-voltages across the capacitor C due to the charge which accumulates in the base of the transistor Q because of the current which passes through the collector-base junction for a short period of time (the "storage" time) immediately after the opening of the transistor M, a Zener diode DZ is connected between the base and ground. The voltage across the capacitor C is thus limited to a predetermined value, that is, to the reverse conduction voltage of the diode DZ.

By means of a suitable selection of the circuit parameters, the above-described circuit according to the invention enables the bipolar power transistor to be kept in the saturation region throughout the time for which it is conductive. This is achieved without the use of additional supplies and with a small number of components all of which, usually with the exception of the capacitor C, can be integrated in the same silicon chip which contains the power device in an emitter-switching configuration, with clear advantages in terms of costs and size.

In a practical embodiment of the invention, the capacitor C had a capacitance of 22 nF, the resistor R1 had a resistance of 700 ohms, the voltage Vin was a sinusoidal voltage of 30 Vpp having a frequency of 40 KHz, and the supply voltage Vdd was 300-400 V.

If it is desired to reduce the capacitance of the capacitor C, for example, in order to reduce the overall size of the circuit, a device constituted by two transistors connected in a Darlington configuration which, as is known, requires a lower driving current, may be used instead of a single bipolar transistor Q.

Another embodiment of the invention which enables a higher mean voltage to be achieved across the capacitor is described below with reference to Figure 7. In this drawing, elements identical to those of Figure 5 are indicated by the same reference numerals or symbols. The circuit differs from that of Figure 5 solely by the addition of a diode D2 in parallel with the resistor R1, and in that there is a Zener diode, in this case indicated D3, in parallel with the capacitor C, instead of a Zener diode between the base of the transistor Q and ground. It will be noted that the diode D2 is oriented with its cathode connected to the cathode of the diode D1.

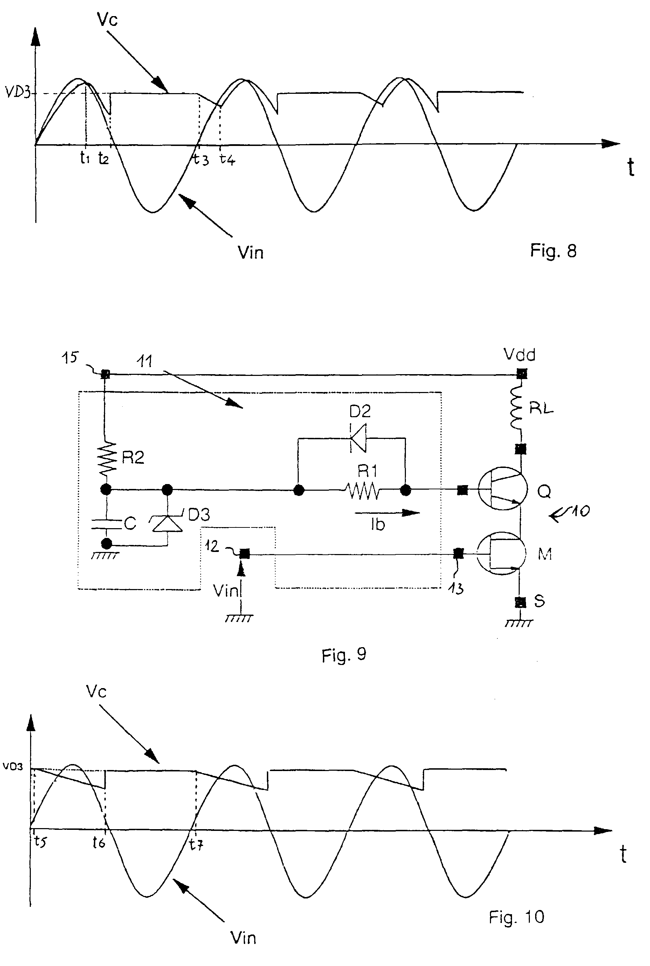

As shown in the graph of Figure 8, the circuit of Figure 7 behaves in a similar manner to that of Figure 5 up to the time t2 at which the transistor M is cut off. After this time, however, the behaviour is different. In fact, after the transistor M is cut off, instead of being transferred to ground through a Zener diode (DZ in Figure 5), the charges which accumulate in the base of the transistor Q are used, at least partially, to charge the capacitor C through the diode D2. It will be noted that the diode D2 is conductive only during this short period of time (the "storage" time of the transistor Q), whereas it is cut off in all other operative conditions of the circuit. The Zener diode D3 serves to limit the voltage Vc at the terminals of the capacitor C by transferring the excess charge to ground.

After the time t2, the voltage Vc across the capacitor increases up to the reverse conduction voltage VD3 of the Zener diode D3 and remains substantially constant, even after the end of the storage time and up to a time t3 shortly after the start of the next positive half-wave when the transistors M and Q become conductive again. In a similar manner to the circuit of Figure 5, the capacitor C supplies charge to the transistor Q until the voltage Vin exceeds the voltage Vc by a value equal to the conduction threshold of the diode D1 at a time t4, after which the voltage Vin starts to charge the capacitor C and to supply the base of the transistor Q again and the cycle is repeated.

In order to speed up the switching of the device 10 in the circuit of Figure 7 as may, however, also be done in the circuits of Figure 5 and of Figure 9, it may be advantageous to connect in series with the gate terminal of the transistor M a squaring circuit, which is indicated by a box 14 shown in broken outline, and which can advantageously be supplied by the voltage at the terminals of the capacitor C.

A device in a Darlington configuration may also be used instead of the transistor Q in this embodiment.

In the embodiment of Figure 9, elements identical or equivalent to those of Figure 7 are indicated by the same reference numerals or symbols. In contrast with the circuit of Figure 7, the capacitor C is not charged by the input voltage Vin because there is no diode D1. However, the capacitor C is charged through a resistor R2 by the supply voltage Vdd supplied to a terminal 15 which may be called the biasing terminal. The resistor R2 may have a very large resistance, for example, 1-2 Mohms if Vdd is 300-400 V and therefore dissipates a low power.

In operation, as shown by the graph of Figure 10, the capacitor C is initially charged to the voltage VD3. Immediately after a time t5 at which the input voltage Vin reaches the conduction threshold of the transistor M, that is, as soon as the transistor Q is made conductive, the capacitor C supplies charge to the base of the transistor Q, thus enabling a current Ib to flow, bringing about and maintaining saturation in the transistor Q. The voltage Vc across the capacitor C thus falls until a time t6 when the transistor M is cut off. At this time, the charges which accumulate in the base as a result of the flow of current through the collector-base junction during saturation quickly recharge the capacitor C up to the voltage of the Zener diode VD3 through the diode D2 in the direction of conduction. The capacitor remains charged to this voltage until the transistor M becomes conductive again at a time t7, immediately after the start of the next positive half-wave and the cycle is repeated.

Although the embodiments described relate to the control of an inductive load, it will be clear to an expert in the art that the circuit according to the invention may also be used with the same advantages for controlling a resistive, capacitive or mixed load.

## Claims

1. A circuit for controlling the switching of a load (RL), comprising:
a control terminal (12),
a device (10) in an emitter-switching configuration, having a first power terminal and a second power terminal and comprising a high-voltage, bipolar power transistor (Q) having a collector terminal connected to the first power terminal, an emitter terminal, and a base terminal (14), a low-voltage switch element (M) having a first terminal connected to the emitter terminal of the bipolar power transistor (Q), a second terminal connected to the second power terminal, and a control terminal (13) connected to the control terminal (12) of the circuit, and
biasing means (11) connected to the base terminal of the bipolar power transistor (Q),
characterized in that the biasing means (11) comprise capacitive means (C) and means (Vin, D1; D2; Vdd, R2) for charging the capacitive means (C).

2. A circuit according to Claim 1, in which the capacitive means (C) are connected, on one side, to the base terminal of the bipolar power transistor (Q) via resistive means (R1) and, on the other side, to a reference voltage terminal (ground), and the charging means comprise a diode (D1) connected between the control terminal (12) of the circuit (10) and the connection point between the capacitive means (C) and the resistive means (R1).

3. A circuit according to Claim 2, in which the charging means comprise a further diode (D2) connected in parallel with the resistive means (R1).

4. A circuit according to Claim 3, comprising a voltage limiter (D3) in parallel with the capacitive means (C).

5. A circuit according to Claim 4, in which the voltage limiter comprises a Zener diode (D3).

6. A circuit according to Claim 1, which comprises a biasing terminal (15) and in which the capacitive means (C) are connected, on one side, to the base terminal of the bipolar power transistor (Q) via resistive means (R1) and, on the other side, to a reference voltage terminal (ground), and the charging means comprise further resistive means (R2) connected between the biasing terminal (15) and the point at which the capacitive means (C) are connected to the resistive means (R1), and a further diode (D2) connected in parallel with the resistive means (R1).

7. A circuit according to Claim 6, further comprising a voltage limiter (D3) in parallel with the capacitive means (C).

8. A circuit according to Claim 7, in which the voltage limiter comprises a Zener diode (D3).

9. A circuit according to any one of the preceding claims, in which the switch element is a field-effect transistor (M).

10. A circuit according to any one of the preceding claims, comprising a squaring circuit (14) between the control terminal (12) of the circuit and the control terminal (13) of the low voltage switch element (M).
